(19) Europäisches Patentamt
European Patent Office
Office européen des brevets

(11) **EP 1 550 214 B1**

(12) **EUROPÄISCHE PATENTSCHRIFT**

(45) Veröffentlichungstag und Bekanntmachung des Hinweises auf die Patenterteilung:
**01.08.2012 Patentblatt 2012/31**

(21) Anmeldenummer: **03750324.0**

(22) Anmeldetag: **05.09.2003**

(51) Int Cl.:
**H03K 17/082** (2006.01)

(86) Internationale Anmeldenummer:
**PCT/DE2003/002957**

(87) Internationale Veröffentlichungsnummer:
**WO 2004/034583 (22.04.2004 Gazette 2004/17)**

(54) **VERFAHREN UND VORRICHTUNG ZUM SCHALTEN EINES HALBLEITER-LEISTUNGSSCHALTERS**

METHOD AND DEVICE FOR SWITCHING A SEMI-CONDUCTOR CIRCUIT BREAKER

PROCEDE ET DISPOSITIF DE COMMUTATION D'UN DISJONCTEUR A SEMICONDUCTEURS

(84) Benannte Vertragsstaaten:
**DE FR GB IT**

(30) Priorität: **09.10.2002 DE 10247109**

(43) Veröffentlichungstag der Anmeldung:
**06.07.2005 Patentblatt 2005/27**

(73) Patentinhaber: **SIEMENS AKTIENGESELLSCHAFT**
**80333 München (DE)**

(72) Erfinder:
• **LUGERT, Günter**
  **93055 Regensburg (DE)**
• **KNORR, Rainer**
  **93055 Regensburg (DE)**
• **BOLZ, Stephan**
  **93102 Pfatter (DE)**
• **GAMULESCU, Tudor-Ion**
  **85354 Freising (DE)**

(56) Entgegenhaltungen:
WO-A-00/19572       WO-A-00/79681
US-A- 5 465 190     US-A- 6 052 268
US-B1- 6 341 073    US-B1- 6 400 581

**Beschreibung**

Die Erfindung betrifft ein Verfahren zum Schalten eines Halbleiter-Leistungsschalters nach dem Oberbegriff von Anspruch 1, insbesondere eines zwischen zwei Energiespeichern angeordneten Halbleiter-Leistungsschalters in einem mit einem Integrierten Starter-Generator ausgerüsteten Kraftfahrzeug-Bordnetz. Sie betrifft auch eine Vorrichtung zur Durchführung dieses Verfahrens nach Anspruch 2.

Im einem Kraftfahrzeug-Bordnetz mit ISG sind Schaltvorgänge zwischen Energiespeichern - Akkumulatoren verschiedener Nennspannungen und Kondensatoren (Zwischenkreiskondensatoren, Doppelschichtkondensatoren) - über Umrichter oder Schaltregler mittels Leistungsschaltern erforderlich, die mittels der Befehle eines Steuergeräts durchgeführt werden.

Bedingung dabei ist, dass vor dem Öffnen eines Schalters der durch ihn fließende Schalterstrom auf 0A gebracht wird, und dass vor dem Schließen eines Schalters die zwischen seinen Schaltkontakten liegende Schalterspannung auf 0V gebracht wird.

Ein Schalterstrom 0A kann beispielsweise durch Abschalten von AC/DC-Umrichter oder DC/DC-Schaltregler erfolgen und stellt in der Praxis kein Problem dar.

Die Regelung auf 0V Schalterspannung, d.h., keine Potentialdifferenz zwischen den Polen des (geöffneten = nicht leitenden) Schalters, erfolgt in der Regel durch gezieltes Umladen eines der Energiespeicher, beispielsweise eines Zwischenkreiskondensators, da dieser in der Regel der kleinere der Energiespeicher ist. Diese Regelung kann auch prinzipiell durch einen Umrichter oder einen zwischen diesem und dem Bordnetz befindlichen Schaltregler erfolgen.

Der Zwischenkreiskondensator hat beispielsweise eine Kapazität von mehreren 10.000$\mu$F, der Doppelschicht-kondensator beispielsweise eine Kapazität von 200F, die Akkumulatoren eine Kapazität von mehreren Ah. Die auszugleichende Schalterspannung kann bis zu 60V betragen.

Bedingt durch das ungünstige Verhältnis von Leistungsfähigkeit von Umrichter (z.B. 6kW) oder Schaltregler (z.B. 1kW) zu der für den Ladungsausgleich (bis 40 Joule) erforderlichen Energie sind dem Spannungsausgleich jedoch in der Praxis enge Grenzen gesetzt.

Werden nun beispielsweise aus Gründen der Zuverlässigkeit und des Platzbedarfs als Schalter Halbleiterschalter eingesetzt, so reicht die so erzielbare Genauigkeit des Spannungsausgleichs nicht aus.

Im normalen Betrieb auftretende Ströme und Leistungen erfordern die Verwendung von Bauelementen (Kondensatoren, Schaltern) mit sehr kleinen Widerständen. Entsprechend hoch fallen bei vorhandenen Spannungsdifferenzen die Ausgleichsströme über dem zu schließenden Schalter aus. Im Extremfall führt dies zur Zerstörung der Halbleiter.

Eine Begrenzung des durch den Schalter fließenden Ausgleichsstromes auf einen ungefährlichen Wert setzt eine Strommessung voraus, die bei der Höhe der auftretenden Ströme einen kostenintensiven Stromsensor erfordert. Außerdem kann der Ausgleichsvorgang nicht zeitoptimiert verlaufen, da bei großer Schalterspannung die Verlustleistung im Schalter hoch ist, was eine weitere mögliche Begrenzung darstellt.

Es ist Aufgabe der Erfindung, ein Verfahren und eine entsprechende Vorrichtung zur Betätigung eines Halbleiter-Leistungs-schalters zu schaffen, die ohne kostenintensiven Stromsensor auskommt und bei welcher der Einschaltvorgang und der Einschaltzustand so geregelt werden, dass auch bei großer Spannungsdifferenz am Schalter die Verlustleistung in den Halbleitern auf einen ungefährlichen Wert begrenzt - und konstant gehalten - wird, damit eine Beschädigung der Halbleiter ausgeschlossen ist.

Diese Aufgabe wird erfindungsgemäß durch ein Verfahren gemäß den Merkmalen von Anspruch 1 und eine Vorrichtung gemäß den Merkmalen des Anspruchs 2 gelöst.

Vorteilhafte Weiterbildungen der Erfindung sind den Unteransprüchen zu entnehmen.

Die Erfindung umfasst die technische Lehre, den Widerstand der Schaltstrecke des Halbleiter-Leistungs-schalters (S1, S2) mittels einer Steuerspannung Vst so zu steuern, dass die Verlustleistung Pist des Leistungsschalters (S1, S2) einen vorgegebenen Sollwert Psoll nicht überschreitet.

Die Verlustleistung Pist des Leistungsschalters wird aus der zwischen den Anschlüssen des Leistungsschalters liegenden Differenzspannung Vdiff ermittelt, wie später noch genauer ausgeführt wird.

Diese Verlustleistung Pist wird anschließend auf einen vorgegebenen Sollwert Psoll geregelt, wobei die Regelgröße als Steuersignal zur Erzeugung der Steuerspannung dient.

Erfindungsgemäß ist vorgesehen, den Schalter als Transfer-Gate auszubilden und mittels einer Ladungspumpe so anzusteuern, dass die Verlustleistung am Schalter geregelt und auf einen vorgegebenen Sollwert begrenzt werden kann.

Vorteilhafte Weiterbildungen der Erfindung sind den Unteransprüchen zu entnehmen.

Ein Ausführungsbeispiel nach der Erfindung wird nachstehend anhand einer schematischen Zeichnung näher erläutert. In der Zeichnung zeigen:

Figur 1    ein Prinzipschaltbild eines 14V/42V-Kraftfahrzeug-Bordnetzes,
Figur 2    ein Prinzipschaltbild eines als Transfer-Gate ausgebildeten Halbleiter-Leistungsschalters,

Figur 3    die Schaltung eines mittels einer Ladungspumpe ansteuerbaren Transfer-Gates,

Figur 4    einen Differenzverstärker mit Gleichrichter zur Bestimmung der Schalterspannung,

Figur 5    einen Analogrechner zur Bestimmung der Verlustleistung am Schalter mit einem nachgeschalteten Zweipunktregler, und

Figur 6    ein Ablaufdiagramm zur Bestimmung der SchalterVerlustleistung.

Figur 7    den Verlauf der zeitvariablen Führungsgröße Vsoll(t), und

Figur 8    eine alternative Ausführung für den Leistungsrechner LR nach Figur 5.

Das erfindungsgemäße Verfahren wird anhand der Ausführungen bezüglich der Vorrichtung näher erläutert.

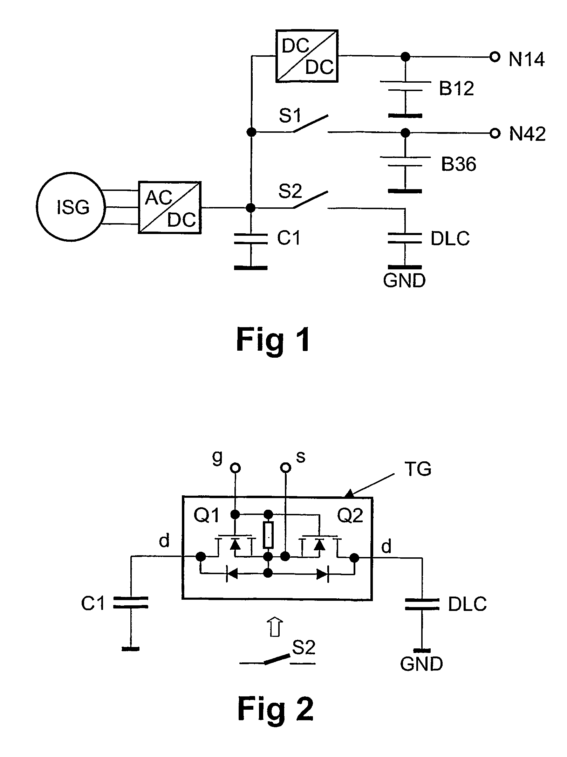

**Figur 1** zeigt ein Prinzipschaltbild eines 14V/42V-Kraftfahrzeug-Bordnetzes mit einem mit einer nicht dargestellten Brennkraftmaschine gekoppelten integrierten Starter-Generator ISG, anhand dessen die Erfindung erläutert wird.

Dieser ISG ist über einen bidirektionalen AC/DC-Wandler AC/DC

a) direkt mit einem Zwischenkreiskondensator C1,

b) über einen Leistungsschalter S2 mit einem Doppelschichtkondensator DLC,

c) über einen Leistungsschalter S1 mit einem 36V-Akkumulator B36 und einem 42V-Bordnetz, und

d) über einen bidirektionalen DC/DC-Wandler DC/DC mit einem 12V-Akkumulator B12 und einem 14V-Bordnetz N14

verbunden.

Erfindungsgemäß soll jeder Leistungsschalter (S1 und S2) als Transfer-Gate ausgebildet sein und mittels der Befehle eines nicht dargestellten Steuergeräts von einer Ladungspumpe angesteuert werden.

**Figur 2** zeigt ein Prinzipschaltbild für einen als Transfer-Gate TG ausgeführten Schalter, beispielsweise für den Schalter S2,der zwischen dem Zwischenkreiskondensator C1 und dem Doppelschichtkondensator DLC angeordnet ist. Falls weitere als Transfer-Gate ausgebildete Schalter erforderlich sind, so sind sie identisch ausgebildet.

Das Transfer-Gate TG besteht aus zwei in Reihe geschalteten MOSFET-Transistoren Q1 und Q2, deren Sourceanschlüsse s und Gateanschlüsse g jeweils miteinander verbunden sind. Die Drainanschlüsse d dienen als Eingang E oder Ausgang A des Schalters.

Da im Bordnetz die Spannungsdifferenzen Vdiff und Stromrichtungen am Schalter beliebiges Vorzeichen bzw. beliebige Richtung haben können, ist die Verwendung von zwei in Reihe geschalteten Halbleitern bzw. Halbleitergruppen erforderlich, von denen jeweils wenigstens einer sperrt. Eine derartige Anordnung ist als Transfer-Gate bekannt, welche die eigentliche Schaltfunktion ausübt.

Die Ansteuerung eines solchen als Transfer-Gate ausgebildeten Schalters erfolgt durch Anlegen einer Steuerspannung zwischen Source- und Gateanschluß. Zum Abbau dieser Steuerspannung ist ein nicht näher bezeichneter Widerstand zwischen Gate- und Sourceanschluß vorgesehen.

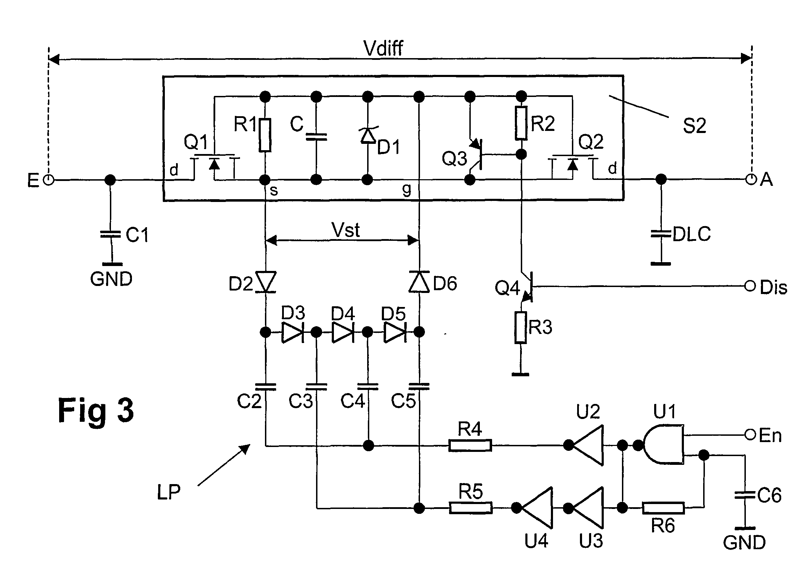

In **Figur 3** ist die Schaltung des mittels einer Ladungspumpe ansteuerbaren, als Transfer-Gate ausgebildeten Schalters S2, der zwischen Zwischenkreiskondensator C1 und Doppelschichtkondensator DLC angeordnet ist, noch einmal dargestellt. Zusätzlich kann, mittels eines Signals Dis über einen weiteren, im Transfer-Gate angeordneten Transistor Q3 (und einen externen Transistor Q4) die Steuerspannung kurzgeschlossen werden, um das Transfer-Gate rasch zu öffnen (nichtleitend zu steuern).

Die an sich bekannte Ladungspumpe LP (Kondensatoren C2 bis C5 und Dioden D3 bis D5) baut eine Steuerspannung zwischen Source- und Gateanschluß des Transfer-Gate (Schalter 2) auf. Sie wird von einem Gatteroszillator (logische Schaltelemente U1 bis U4) mit Enablefunktion versorgt. So kann der Oszillator und mit ihm die Ladungspumpe LP durch ein logisches Steuersignal En (enable) ein- und ausgeschaltet werden. Die Erzeugung dieses Steuersignals En wird weiter unten erklärt.

Durch Einschalten der Ladungspumpe LP mittels eines Signals En (Enable) wird zwischen Source- und Gateanschluß eine positive Steuerspannung aufgebaut, wodurch Schalter S2 (Transfer-Gate) entsprechend leitend wird. Nach dem Abschalten wird diese Spannung wieder abgebaut, wodurch Schalter S2 wieder nichtleitend wird. Das Ein- und Ausschalten erfolgt zeitlich kontrolliert, d.h., dass durch gezieltes Ein- und Ausschalten der Ladungspumpe das Transfer-Gate in einem analogen Leitungszustand gehalten werden kann.

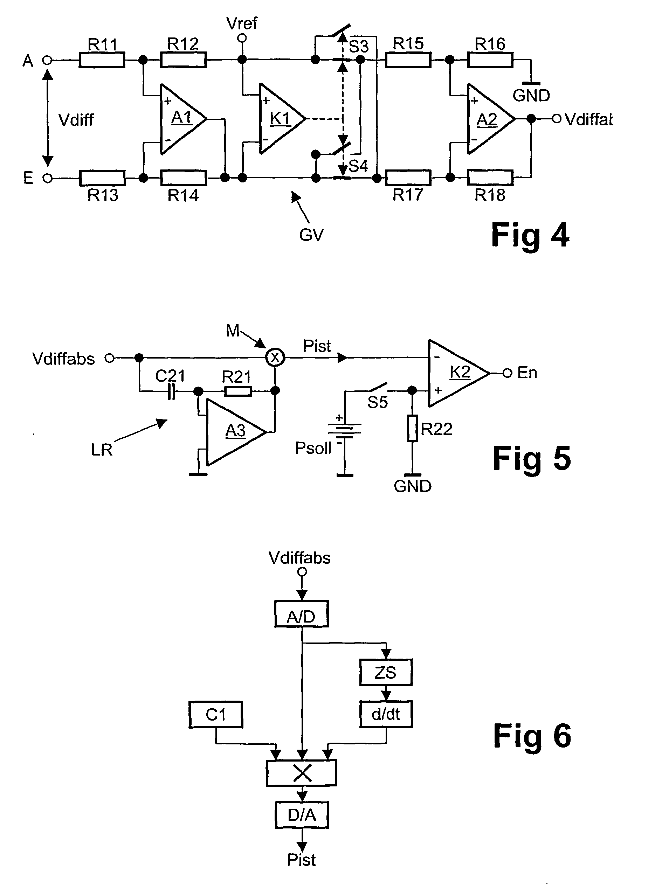

Die Spannung (Potentialdifferenz) Vdiff zwischen den Anschlüssen A und E des Schalters S2 (Transfer-Gate) wird durch einen nachfolgenden, in **Figur 4** dargestellten Spannungsgeber GV ermittelt und in einen auf Bezugspotential GND bezogenen Absolutwert Vdiffabs der Schalterspannung umgewandelt. Die Spannung Vdiff wird in einem Differenzverstärker A1 und R11 bis R14 erfasst und in eine auf eine vorgegebene Referenzspannung Vref bezogene Gleichspannung umgewandelt. Beträgt die Potentialdifferenz 0V, so ist am Ausgang des Differenzverstärkers A1 eine Spannung Vref abgreifbar.

Ein dem Differenzverstärker A1 nachgeschalteter Gleichrichter K1 wertet das auf Referenzspannung Vref bezogene Ausgangssignal des Differenzverstärkers A1 aus. Er steuert zwei miteinander gekoppelte Schalter S3 und S4 (beispielsweise zwei CMOS-Umschalter) so, dass ein nachfolgender, zweiter Differenzverstärker A2, beschaltet mit

3

Widerständen R15 bis R18, stets eine positive Eingangsspannung erhält.

Auf diese Weise erhält man am Ausgang des Differenzverstärkers A2 den Absolutwert Vdiffabs der auf Bezugspotential GND bezogenen Schalterspannung Vdiff.

Zur Bestimmung der Schalterverlustleistung Pist muss dieser Absolutwert Vdiffabs der Schalterspannung weiter aufbereitet werden.

Um eine kostspielige Messung des Schalterstromes $I_S$ zu vermeiden, kann man diesen auch aus dem Differential der Schalterspannung Vdiffabs ermitteln, da dieser Strom ja zur Umladung des Zwischenkreiskondensators C1 dient:

$$I_S = C1*d(Vdiffabs)/dt, \qquad C1 \text{ ist dabei konstant} \qquad (1)$$

Zur Ermittlung der Leistung Pist am Schalter ist die Bestimmung des Produkts aus Schalterspannung $V_S$ und Schalterstrom $I_S$ erforderlich:

$$Pist = V_S*I_S = Vdiffabs*C1*d(Vdiffabs)/dt \qquad (2)$$

Gemäß **Figur 5** wird zur Berechnung der Schalterleistung Pist ein Leistungsrechner LR herangezogen. Dieser besteht aus einem mit einem Kondensator C21 und einem Widerstand R21 beschalteten Analogrechner A3 und einem Multiplizierer M. Der Analogrechner A3 berechnet gemäß Formel 2 aus der Eingangsgröße Vdiffabs das zeitliche Differential d(Vdiffabs)/dt, welches im Multiplizierer M mit der Eingangsgröße Vdiffabs multipliziert wird.

Der Wert des Zwischenkreiskondensators C1 ist dabei als Verstärkungsfaktor berücksichtigt. Er kann aber auch durch Variation des Sollwerts Psoll eines nachstehend beschriebenen Zweipunktreglers K2 berücksichtigt werden. Das Ausgangssignal des Multiplizierers M ist proportional zur Schalterleistung Pist.

In einem nachfolgenden Zweipunktregler K2 wird das Ausgangssignal Pist des Multiplizierers M auf einen als Führungsgröße dienenden Sollwert Psoll geregelt, welcher als ein dem Sollwert Psoll entsprechender Spannungswert am nichtinvertierenden Eingang des Zweipunktreglers K2 angelegt wird. Der nichtinvertierende Eingang des Zweipunktreglers K2 ist über einen Widerstand R22 direkt mit Bezugspotential GND verbunden. Über einen Schalter S3 wird dem nichtinvertierenden Eingang des Zweipunktreglers K2 der Sollwert Psoll zugeführt. Am Ausgang des Zweipunktreglers K2 ist das Signal En abgreifbar, welches dem Gatteroszillator U1 bis U4 nach Figur 3 als Steuersignal zugeführt wird:

Pist<Psoll: En = High → der Gatteroszillator U1 schwingt an, die Ladungspumpe erzeugt eine steigende Gatespannung, wodurch das Transfer-Gate stärker leitet. Die Schalterspannung (zwischen A und E) sinkt und damit auch die gemessene Spannung Vdiffabs. Als Folge davon wird der Wert von Pist solange steigen, bis er den Sollwert Psoll überschreitet.

Pist>Psoll: En = Low → der Gatteroszillator U1 stoppt. Die Ladungspumpe liefert keine Gatespannung mehr, diese sinkt langsam. Bei Unterschreiten von Psoll durch Pist schaltet Regler K2 wieder auf High und der Zyklus beginnt erneut.

Der Sollwert Psoll kann durch Öffnen des Schalters S3 abgeschaltet werden, wobei der Widerstand R22 dann für Nullpotential sorgt und S2 sicher in den Sperrzustand geht.

Die Berechnung der Schalterleistung Pist kann auch mittels eines in einem Mikrocontroller μC abgelegten Softwareprogramm erfolgen, dessen Ablaufdiagramm in **Figur 6** dargestellt ist. Dadurch entfallen Analogrechner A3 und Multiplizierer M.

Das Ausgangssignal Vdiffabs des Differenzverstärkers A2 (Figur 4) wird in einem A/D-Konverter A/D laufend digitalisiert und in einem Zwischenspeicher ZS gespeichert und anschließend per Software differenziert (d/dt).

In einem weiteren Schritt wird das Differential mit dem Ausgangssignal des A/D-Konverters A/D und mit einer Konstante C1 multipliziert (X) und wieder in einen Analogwert zurückgewandelt (D/A). Dieser Analogwert ist proportional zur Schalterleistung Pist und wird dem invertierenden Eingang des Reglers K2 (in Figur 5) zugeführt.

Differentiation und Multiplikation sind sowohl hardware- als auch software-mäßig aufwendige Verfahren. Beide Verfahren können vermieden werden.

Da die relevanten Systemgrößen (Kapazität, Differenzspannung Vdiffabs und Schalterleistung Psoll) bekannt bzw. messbar sind, kann der Regelkreis zur Führung des Umladevorgangs auch vereinfacht werden.

Aus diesen Größen kann - rechnerisch oder empirisch - eine einer konstanten Schalterleistung Psoll zugeordnete, zeitvariable Sollspannung Vsoll(t) ermittelt und gespeichert werden, die als Führungsgröße für einen Umladevorgang, beginnend mit der Differenzspannung Vdiffabs am Beginn eines Umladevorgangs, bis zu dem Zeitpunkt, an dem der Umladevorgang beendet ist und Vdiffabs = 0V wird.

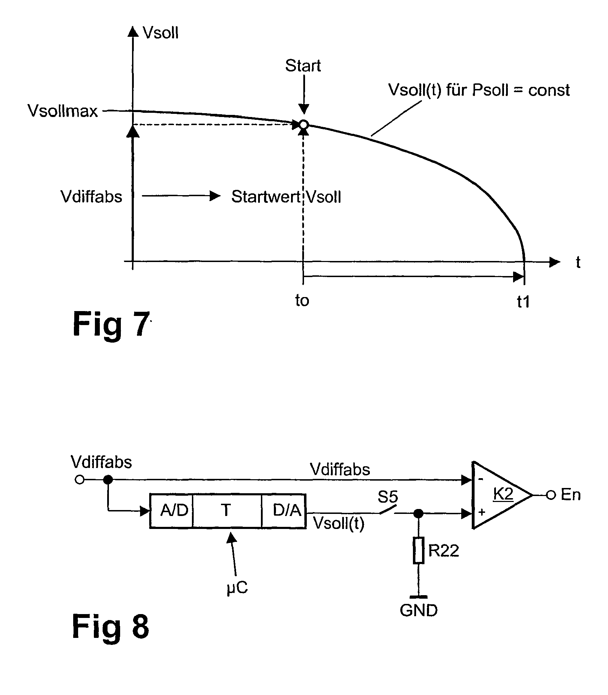

Für diese Kurve ergibt sich, wie in Figur 7 dargestellt, ein parabelförmiger Verlauf über der Zeit. Die Führung der Regelschleife erfolgt nun durch diese zeitvariable Spannung Vsoll(t), deren Startwert dem aktuellen Wert der Differenzspannung Vdiffabs am Beginn (to) des Umladevorgangs entspricht.

Die Erzeugung dieser zeitvariablen Sollspannung Vsoll(t) als Führungsgröße kann, wie in **Figur 8** dargestellt, mittels eines Mikrocontrollers μC erfolgen, in welchem der zeitliche Verlauf der Sollspannung Vsoll(t) in einer Tabelle T gespeichert ist. Damit werden die hard- oder softwaremäßigen Differenzierer und Multiplizierer nach den Figuren 5 und 6 entbehrlich.

Der Absolutwert der Differenzspannung Vdiffabs (Ausgangsspannung des zweiten Differenzverstärkers A2 von Figur 4) wird in diesem Ausführungsbeispiel direkt dem invertierenden Eingang des Zweipunktreglers K2 und dem Eingang des Mikrocontrollers μC zugeführt. Diese Differenzspannung Vdiffabs wird im Mikrocontroller μC zunächst A/D-gewandelt.

Mit dem nicht dargestellten Befehl zum Ladungsausgleich der beiden durch den Schalter - hier S2 - verbundenen Energiespeicher - hier C1 und DLC - wird (Figur 7), beginnend zum Zeitpunkt to mit dem Startwert Vsoll(to), der der Differenzspannung Vdiffabs in diesem Zeitpunkt to entspricht und der aus der Tabelle T entnommen wird, die zeitvariable Sollspannung Vsoll(t) nach D/A-Wandlung dem nichtinvertierenden Eingang des Zweipunktreglers K2 über den Schalter S3 zugeführt und entsprechend der in Figur 7 dargestellten Kurve nachgeführt, bis sie im Zeitpunkt t1 zu Null wird.

Damit wird der Ladungsausgleich zwischen den beiden Energiespeichern mit vorgegebener, konstanter Schalter-Verlustleistung durchgeführt, welcher im Zeitpunkt t1 beendet ist.

## Patentansprüche

1. Verfahren zum Schalten eines Halbleiter-Leistungsschalters (S1, S2), wobei der Widerstand der Schaltstrecke des Halbleiter-Leistungsschalters (S1, S2) mittels einer Steuerspannung Vst so gesteuert wird, dass die Verlustleistung Pist des Leistungsschalters (S1, S2) einen vorgegebenen Sollwert Psoll nicht übersteigt, wobei

   - zur Ermittlung der Verlustleistung Pist des Leistungs-schalters (S1, S2) aus der zwischen dessen Anschlüssen (S1, S2) liegenden Differenzspannung Vdiff der auf Bezugspotential GND bezogene Absolutwert Vdiffabs dieser Differenzspannung Vdiff gebildet wird,
   - das zeitliche Differential d(Vdiffabs)/dt dieser Differenzspannung Vdiff gebildet wird,
   - gemäß der Formel

$$\text{Pist} = V_S * I_S = \text{Vdiffabs} * d(\text{Vdiffabs})/dt * C1,$$

$$\text{mit } V_S = \text{Schalterspannung Vdiffabs},$$

$$I_S = d(\text{Vdiffabs})/dt * C1,$$

$$C1 = \text{const},$$

   das zeitliche Differential d(Vdiffabs)/dt mit dem Absolutwert Vdiffabs und einem Konstantwert C1 multipliziert wird, wobei das Produkt der Verlustleistung Pist des Leistungsschalters (S1, S2) entspricht,
   - die Verlustleistung Pist auf einen vorgegebenen Sollwert Psoll geregelt wird, und
   - die Regelgröße als Steuersignal En zur Erzeugung der Steuerspannung Vst dient.

2. Vorrichtung zur Durchführung des Verfahrens nach Anspruch 1 zur Betätigung eines Leistungsschalters (S1, S2), insbesondere eines zwischen zwei Energiespeichern (C1, DLC, B36) angeordneten Halbleiter-Leistungsschalters (S1, S2) in einem mit einem Integrierten Starter-Generator (ISG) ausgerüsteten Kraftfahrzeug-Bordnetz,

   - wobei der Leistungsschalter (S1, S2) als Transfer-Gate (TG) mit zwei in Reihe geschalteten Halbleitern (Q1, Q2) ausgebildet ist, von denen im Sperrzustand des Leistungs-schalters (S1, S2) jeweils wenigstens einer sperrt, und
   - wobei zur Erzeugung der Steuerspannung Vst eine Ladungspumpe (LP) vorgesehen ist, mittels welcher die Halbleiter (Q1, Q2) des Leistungsschalters (S1, S2) im Leitzustand jeweils nur soweit aufgesteuert werden, dass die Verlustleistung Pist des Leistungsschalters (S1, S2) einen vorgegebenen Sollwert Psoll nicht überschreitet,
   **dadurch gekennzeichnet, dass** im Transfer-Gate (TG) ein Transistor (Q3) vorgesehen ist, dessen Kollektor-Emitterstrecke zwischen den miteinander verbundenen Gateanschlüssen (g) und den miteinander verbundenen Sourceanschlüssen (s) der zwei in Reihe geschalteten Halbleiter (Q1, Q2) angeordnet ist, welcher mittels eines externen Signals (Dis) in den Leitzustand versetzbar ist, um das Transfer-Gate (TG) rasch nichtleitend zu steuern.

## Claims

1. Method for switching a semiconductor circuit breaker (S1, S2), with the resistance of the breaker gap of the semiconductor circuit breaker (S1, S2) being controlled by a control voltage Vst so that the power loss Pist of the circuit breaker (S1, S2) does not exceed a predetermined setpoint Psoll, wherein

   - for determining the power loss Pist of the circuit breaker (S1, S2), from the differential voltage Vdiff lying between its terminals (S1, S2), the absolute value Vdiffabs of this differential voltage Vdiff referred to the reference potential GND is formed,
   - the time differential d(Vdiffabs)/dt of this differential voltage Vdiff is formed,
   - according to the formula

$$\text{Pist} = V_S * I_S = \text{Vdiffabs} * d(\text{Vdiffabs})/dt * C1,$$
$$\text{with } V_S = \text{switch voltage Vdiffabs},$$
$$I_S = d(\text{Vdiffabs})/dt * C1,$$
$$C1 = \text{const},$$

   - the time differential d(Vdiffabs)/dt is multiplied by the absolute value Vdiffabs and a constant value C1, with the product corresponding to the power loss Pist of the circuit breaker (S1, S2), and
   - the power loss Pist is regulated to a predetermined setpoint Psoll, and
   - the control variable serves as the control signal En for generating the control voltage Vst.

2. Device for executing the method according to claim 1, for actuating a circuit breaker (S1, S2), in particular a semiconductor circuit breaker (S1, S2) arranged between two energy storage devices (C1, DLC, B36) in a wiring system of a vehicle equipped with an integrated starter-generator (ISG),

   - with the circuit breaker (S1, S2) being embodied as a transfer gate (TG) with two semiconductors (Q1, Q2) connected in series, of which at least one blocks in each case in the blocking state of the circuit breaker (S1, S2) and
   - with a charge pump (LP) being provided to generate the control voltage Vst, by means of which the semiconductors (Q1, Q2) of the circuit breaker (S1, S2) are only controlled in the conductive state such that the power loss Pist of the circuit breaker (S1, S2) does not exceed a predetermined setpoint value Psoll,
   **characterised in that** a transistor (Q3) is provided in the transfer gate (TG), of which the collector-emitter path is disposed between the gate terminals (g) connected to one another and the source terminals (s) connected to one another of the two semiconductors (Q1, Q2) connected in series, which is able to be put into the conductive state by means of an external signal (Dis) in order to quickly make the transfer gate (TG) non-conductive.

## Revendications

1. Procédé de commutation d'un disjoncteur (S1, S2) à semiconducteurs, dans lequel on commande la résistance de la section de commutation du disjoncteur (S1, S2) à semiconducteurs au moyen d'une tension Vst de commande, de manière à ce que la puissance Pist dissipée du disjoncteur (S1, S2) ne dépasse pas une valeur Psoll de consigne prescrite, dans lequel

   - pour la détermination de la puissance Pist dissipée du disjoncteur (S1, S2) à partir de la différence Vdiff de tension entre ses bornes (S1, S2), on forme la valeur Vdiff absolue rapportée au potentiel GND de référence de cette différence Vdiff de tension,
   - on forme la différentielle en fonction du temps d(Vdiffabs )/dt de cette différence Vdiff de tension,

- suivant la formule

$$\texttt{Pist = V}_S\texttt{*I}_S\texttt{ = Vdiffabs*d(Vdiffabs)/dt*C1,}$$
$$\texttt{avec V}_S\texttt{ = tension Vdiffabs de disjoncteur,}$$
$$\texttt{I}_S\texttt{ = d(Vdiffabs)/dt*C1,}$$
$$\texttt{C1 = constante,}$$

on multiplie la différentielle en fonction du temps d(Vdiffabs)/dt par la valeur Vdiffabs absolue et par une constante C1, le produit correspondant à la puissance Pist dissipée du disjoncteur (S1, S2),
- on règle la puissance Pist dissipée à une valeur Psoll de consigne prescrite, et
- on se sert de la grandeur de réglage comme signal En de commande pour la production de la tension Vst de commande.

2. Dispositif pour effectuer le procédé suivant la revendication 1 pour actionner un disjoncteur ( S1, S2 ), notamment un disjoncteur ( S1, S2 ) à semiconducteurs monté entre deux accumulateurs ( C1, DLC, B36 ) d'énergie, dans un réseau de bord de véhicule automobile équipé d'un démarreur dynamo ( ISG ) intégré,

- dans lequel le disjoncteur ( S1, S2 ) est constitué en porte ( TG ) de transfert ayant deux semiconducteurs ( Q1, Q2 ) montés en série dont, à l'état bloqué du disjoncteur ( S1, S2 ), respectivement au moins un bloque, et
- dans lequel, pour la production de la tension Vst de commande, il est prévu une pompe ( LP ) de charge, au moyen de laquelle les semiconducteurs ( Q1, Q2 ) du disjoncteur ( S1, S2 ) sont mis à l'état passant seulement tant que la puissance Pist dissipée du disjoncteur ( S1, S2 ) ne dépasse pas une valeur Psoll de consigne prescrite,
**caractérisé en ce que**, dans la porte ( TG ) de transfert, est prévu un transistor ( Q3 ), dont la section collecteur-émetteur est disposée entre les bornes ( g ) de grille reliées entre elles et les bornes ( s ) de source reliées entre elles des deux semiconducteurs ( Q1, Q2 ) montés en série, section qui peut être mise à l'état passant au moyen d'un signal ( Dis ) extérieur, pour mettre rapidement à l'état non conducteur la porte ( TG ) de transfert.

**Fig 1**

**Fig 2**

Fig 3

EP 1 550 214 B1

**Fig 4**

**Fig 5**

**Fig 6**

Vsoll

Start

Vsoll(t) für Psoll = const

Vsollmax

Vdiffabs → Startwert Vsoll

to          t1

t

## Fig 7

Vdiffabs

Vdiffabs

A/D | T | D/A

Vsoll(t)

S5

K2 ─o En

R22

GND

μC

## Fig 8

11